Europäisches Patentamt

European Patent Office

Office européen des brevets

(11) Numéro de publication: **0 037 760**
**A1**

## (12) DEMANDE DE BREVET EUROPEEN

(21) Numéro de dépôt: **81400427.1**

(22) Date de dépôt: **19.03.81**

(51) Int. Cl.³: **G 06 K 19/06**

(30) Priorité: **04.04.80 FR 8007644**

(43) Date de publication de la demande:
**14.10.81 Bulletin 81/41**

(84) Etats contractants désignés:
**BE CH DE GB IT LI NL SE**

(71) Demandeur: **SOCIETE FLONIC**
**12, Place des Etats-Unis**
**F-92541 Montrouge(FR)**

(72) Inventeur: **Guion, Christian**
**28, Allée du Moulin de Migneaux**
**F-91370 Verrieres-le-Buisson(FR)**

(74) Mandataire: **Havre, Henri**
**GIERS SCHLUMBERGER 12, Place des Etats-Unis**
**F-92124 Montrouge(FR)**

(54) Perfectionnements aux cartes à mémoire.

(57) Carte à mémoire contenant un circuit électronique (11) noyé dans le matériau plastique de la carte (20).

En vue d'éviter l'appartition de potentiels électrostatiques nuisibles pour l'exploitation du circuit électronique (11) un volume conducteur (22) équipotentiel entoure au moins partiellement le circuit. Ce volume peut être réalisé au moyen d'un enrobage plastique chargé d'éléments conducteurs ou au moyen d'un écran formé par une enveloppe conductrice noyée dans le matériau plastique.

Applications aux cartes de paiement pour la prise en compte de transactions bancaires ou commerciales.

Fig. 7

## Perfectionnements aux cartes à mémoire

La présente invention est relative aux cartes à mémoire portatives et plus particulièrement aux cartes contenant un circuit électronique sous forme de circuit intégré comprenant une mémoire et des circuits de traitement de données.

On sait que de telles cartes sont utilisables comme cartes d'identification ou d'accès contrôlé, cartes de crédit ou de paiement, ou plus généralement comme cartes de transactions pour la prise en compte d'opérations bancaires ou commerciales. Dans la suite de cet exposé, on utilisera l'expression "carte à mémoire" pour désigner une carte du genre ci-dessus, quelle que soit son utilisation.

Dans une carte à mémoire, la pastille formant le circuit électronique est enrobée dans un matériau plastique isolant constituant la carte proprement dite aux dimensions normalisées. Le circuit contenu dans la pastille est muni de conducteurs aboutissant à des bornes de contacts, externes ou internes, par exemple suivant la demande de brevet frnaçais n° 79-29115 déposée par la Demanderesse le 27 Novembre 1979 qui permettent de connecter électriquement ce circuit avec un appareil de transfert pour lire et/ou écrire des données dans la mémoire de la carter.

Il peut se produire que, à la suite de frottements par exemple, des charges électrostatiques prennent naissance à la surface et dans le matériau plastique constituant la carte et que ces charges locales créent des potentiels électrostatiques nuisibles non seulement pour l'exploitation des données de la carte, mais pour le circuit électronique lui-même qui risque d'être endommagé, en particulier si ce circuit est réalisé en semi-conducteurs suivant la technique MOS.

L'invention a donc pour objet une carte à mémoire du genre indiqué ci-dessus dans laquelle des moyens sont prévus pour éviter l'apparition et le développement de tels potentiels électrostatiques.

La carte, suivant l'invention, comporte un circuit électronique sous forme de circuit intégré noyé dans un matériau plastique isolant, ledit circuit étant muni de conducteurs reliés à des bornes de contacts permettant de connecter électriquement la carte avec un appareil de transfert de données, et elle est caractérisée en ce qu'elle comporte, en outre, des moyens pour créer un volume conducteur équipotentiel entourant au moins partiellement ledit circuit électronique et à l'intérieur duquel les charges électrostatiques parasites tendent à se répartir de façon équipotentielle.

Lesdits moyens permettant la création d'un volume conducteur équipotentiel autour du circuit électronique peuvent être constitués soit par un enrobage en matériau plastique chargé d'éléments conducteurs, soit par un écran formé par une enveloppe conductrice noyée dans le matériau plastique de la carte, soit par une combinaison de ces deux dispositions.

L'utilisation d'un matériau chargé d'éléments conducteurs, c'est-à-dire conducteur dans la masse, permet aux charges électriques parasites de s'écouler

- 3 -

et de se répartir de façon équipotentielle en évitant que subsistent des charges locales suffisamment élevées pour agir sur le circuit intégré de la carte et perturber notamment la mémoire de données. De même,l'utilisation d'une enceinte conductrice permet aussi la création d'un volume équipotentiel en son intérieur mettant le circuit à l'abri de l'influence des charges d'électricité statique.

L'invention sera mieux comprise en se référant à la description qui va suivre en relation avec le dessin annexé, représentant à titre d'exemples non limitatifs, divers modes de réalisation conformes à l'invention. Sur ce dessin :

- la fig. 1 représente schématiquement en coupe longitudinale une carte à mémoire à contacts internes suivant un premier mode de réalisation conforme à l'invention.

- la fig. 2 montre une carte à mémoire à contacts externes réalisée suivant le mode précédent.

- la fig. 3 représente schématiquement une carte à mémoire à contacts internes suivant un autre mode de réalisation.

- la fig. 4 montre une carte à mémoire à contacts externes réalisée suivant le mode de la fig. 3.

- les fig. 5 et 6 représentent une carte à mémoire utilisant simultanément les dispositions des deux modes précédents.

- la fig. 7 représente un autre mode de réalisation suivant l'invention.

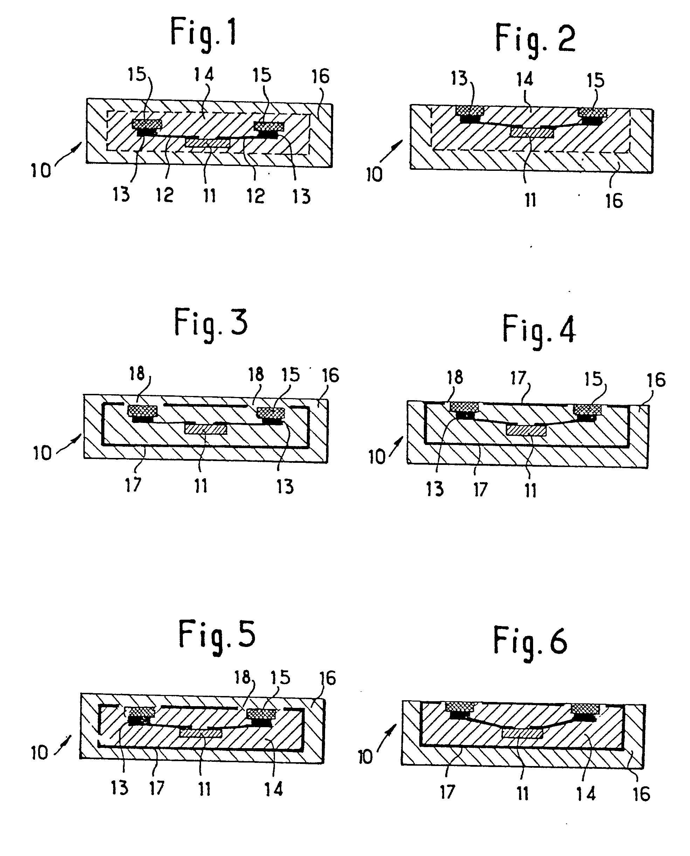

Sur la fig. 1, on voit une carte à mémoire 10, représentée en coupe longitudinale, dans laquelle un circuit électronique 11, tel qu'un circuit intégré sous forme de pastille, relié par des conducteurs 12 à des bornes de contacts internes 13, est enrobé dans un matériau plastique 14. Ce matériau 14 est par exemple constitué par une mousse de polyuréthane, ou plus généralement par un élastomère antistatique et conducteur de l'électricité. Les contacts 13 ont été préalablement recouverts d'un matériau plastique perforable 15, comme il est décrit dans la demande de brevet français précitée. L'ensemble des éléments 11 à 15 est ensuite noyé ou enrobé dans un matériau plastique 16 qui constitue la carte définitive 10 aux dimensions normalisées. Le matériau 14 crée autour du circuit 11 et de ses éléments 12, 13 un volume conducteur pour éviter l'accumulation locale de charges électrostatiques en facilitant l'écoulement et la répartition de ces charges de façon équipotentielle.

La conductibilité du matériau 14 est choisie suffisante pour éviter cette accumulation, mais cependant trop faible pour provoquer un court-circuit entre conducteurs ou bornes de contact voisins avec les tensions normalement utilisées dans l'appareil de transfert servant au traitement des données contenues dans le circuit 11. La résistivité du matériau 14 est par exemple choisie de manière à créer une résistance de l'ordre de 1 k$\Omega$ à 10 k$\Omega$ entre contacts voisins.

La fig. 2 montre une carte à mémoire réalisée suivant le mode précédent, mais avec des bornes de contact extérieures. Dans cette figure et les suivantes, on utilisera les mêmes références pour repérer des éléments analogues. Comme dans le cas de la fig. 1, le circuit 11 avec ses bornes de contacts 13 et leur revêtement perforable 15 est d'abord enrobé dans le matériau conducteur 14 de manière que celui-ci affleure au niveau du revêtement 15 des contacts 13 et présente en plan une surface entourant à la fois le circuit 11 et ses bornes 13. Ce premier ensemble est ensuite enrobé partiellement dans le matériau 16 donnant à la carte 10 son format définitif, tout en laissant libre le recouvrement le matériau conducteur 14 dans la partie centrale de la carte à sa partie supérieure.

La fig. 3 montre un autre mode de réalisation d'une carte à mémoire dans lequel on utilise un écran électrostatique pour créer le volume conducteur équipotentiel autour du circuit électronique de la carte. Le circuit 11 et ses éléments 12, 13, 15 est placé à l'intérieur d'une enveloppe conductrice 17 constituée par une ou plusieurs feuilles minces en métal électriquement bon conducteur ou d'un isolant métallisé, avant d'être enrobé dans le matériau 16 formant la carte à ses dimensions définitives. L'enveloppe conductrice 17 présente naturellement des ouvertures 18 prévues à l'aplomb des bornes 13 et permettant le passage des contacts mobiles de l'appareil de transfert pour venir palper les contacts correspondantms de la carte 10. L'enveloppe 17 crée ainsi autour du circuit 11 et de ses éléments un volume conducteur équipotentiel jouant le rôle de cage de Faraday et le mettant à l'abri des potentiels électrostatiques parasites extérieurs.

On a représenté fig. 4 une carte à mémoire à contacts superficiels réalisée d'après le mode précédent, la partie supérieure de l'enveloppe 17 affleurant dans ce cas à la surface de la carte 10.

La fig. 5 représente une carte à mémoire à contacts internes dans laquelle on a utilisé simultanément les dispositions des fig. 1 et 3, c'est-à-dire dans laquelle le matériau conducteur 14 est lui-même entouré d'une enveloppe conductrice 17 avant enrobage dans le matériau 16 de façon à augmenter encore l'effet de protection contre les charges électrostatiques extérieures.

La fig. 6 représente une carte à mémoire à contacts externes présentant la double disposition de protection de la figure précédente.

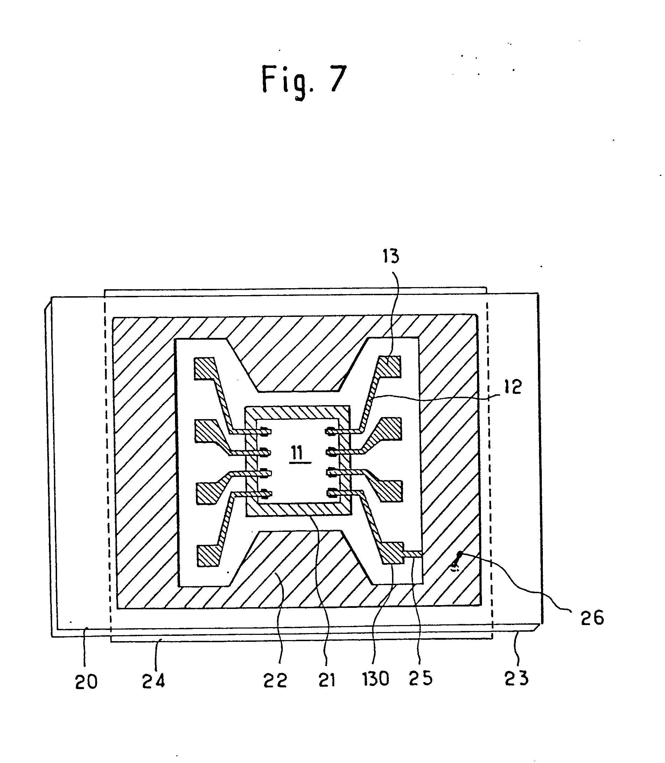

Dans le cas où la pastille de circuit intégré est montée sur un film souple isolant, communément appelé TAB (transport automatique sur bande), auquel elle est reliée par des conducteurs obtenus par découpage chimique d'une métallisation déposée sur ce film, un autre mode de réalisation de l'enveloppe conductrice consiste avantageusement à conserver ladite métallisation du film dans une zone entourant la pastille et ses conducteurs pour former, sur une des faces du circuit, une partie de l'enveloppe conductrice jouant le rôle d'écran électrostatique. La fig. 7 représente schématiquement une vue en plan de ce mode de réalisation. Sur cette figure, on voit le circuit 11 rattaché par ses conducteurs 12 aux contacts 13 qui reposent sur les bords d'une ouverture 21 ménagée dans un substrat constitué par un film souple 20, par exemple en matériau polyamide, tel que le Kapton (marque déposée) fabriqué par la Société du Pont de Nemours. Les conducteurs 12 et les contacts 13 sont obtenus, de façon connue, par une métallisation préalable du film 20 et par le détourage de cette métallisation, par exemple par attaque chimique, suivant la configuration des tracés conducteurs que l'on désire conserver.

L'invention prévoit de conserver en outre la métallisation initiale du film 20 dans une zone 22 entourant les contacts 13 et l'ouverture 21 de manière que cette métallisation supplémentaire 22 forme la première partie de l'écran électrostatique sur la face supérieure du circuit 11. De préférence, la métallisation 22 est reliée par un tracé conducteur 25 à un point de référence de tension, tel que la borne 130 à zéro volt. La seconde partie de l'écran électrostatique sur la face inférieure du circuit 11 peut être obtenue soit par une métallisation supplémentaire de l'autre côté 23 du film 20 dans une zone correspondant à la zone 22, soit par l'adjonction d'une mince feuille plastique métallisée 24. Les deux métallisations supérieure 22 et inférieure 23 ou 24, sont reliées ensemble par une liaison conductrice 26 traversant le film 20 de manière que toutes deux soient portées au même potentiel, par exemple au zéro volt. Bien entendu, l'ensemble ainsi métallisé sur ses deux faces est ensuite noyé dans le matériau plastique donnant à la carte son format définitif comme dans les cas précédents.

REVENDICATIONS

1 - Carte à mémoire portative du genre comportant un circuit électronique sous forme de circuit intégré noyé dans un matériau plastique isolant, ledit circuit étant muni de conducteures reliés à des bornes de contacts permettant de connecter électriquement la carte avec un appareil de transfert de données, caractérisée en ce qu'elle comporte, en outre, des moyens pour créer un volume conducteur équipotentiel entourant au moins partiellement ledit circuit électronique et à l'intérieur duquel les charges électrostatiques parasites tendent à se répartir de façon équipotentielle.

2 - Carte à mémoire suivant la revendication 1, caractérisée en ce que lesdits moyens de création d'un volume conducteur sont constitués par un enrobage de matériau plastique chargé d'éléments conducteurs.

3 - Carte à mémoire suivant la revendication 2, caractérisée en ce que la résistivité dudit matériau plastique chargé d'éléments conducteurs est choisie de manière à créer une résistance de l'ordre de 1 k $\Omega$ à 10 k $\Omega$ entre bornes de contacts voisins.

4 - Carte à mémoire suivant la revendication 1, caractérisée en ce que lesdits moyens de création d'un volume conducteur sont constitués par une enveloppe conductrice.

5 - Carte à mémoire suivant les revendications 2 et 4, caractérisée en ce que lesdits moyens de création d'un volume conducteur sont constituée par un enrobage de matériau plastique chargé d'éléments conducteurs placé à l'intérieur d'une enveloppe conductrice.

6 - Carte à mémoire suivant la revendication 2, caractérisée en ce que le matériau plastique charge d'éléments conducteurs est un élastomère antistatique.

7 - Carte à mémoire suivant la revendication 6, caractérisée en ce que ledit élastomère est une mousse de polyuréthane.

8 - Carte à mémoire suivant la revendication 4, dans laquelle le circuit électronique est monté dans un film souple auquel il est relié par des conducteurs, caractérisée en ce que ladite enveloppe conductrice comporte une métallisation sur au moins une des faces du film dans une zone entourant le circuit et ses conducteurs.

9 - Carte à mémoire suivant la revendication 8, caractérisée en ce que ladite enveloppe conductrice comporte en outre une métallisation supplémentaire sur l'autre face du film dans une zone analogue.

10- Carte à mémoire suivant la revendication 8, caractérisée en ce que ladite enveloppe conductrice comporte en outre une feuille conductrice disposée sur l'autre face non métallisée du film.

11- Carte à mémoire suivant la revendication 8 ou 9, caractérisée en ce que la métallisation est portée à un point de référence de tension.

## Fig.1

## Fig. 2

## Fig. 3

## Fig. 4

## Fig.5

## Fig. 6

# Fig. 7

**0037760**

Office européen
des brevets

**RAPPORT DE RECHERCHE EUROPEENNE**

Numéro de la demande

EP 81 40 0427

| DOCUMENTS CONSIDERES COMME PERTINENTS | | | CLASSEMENT DE LA DEMANDE (Int. Cl.³) |
|---|---|---|---|
| Catégorie | Citation du document avec indication, en cas de besoin, des parties pertinentes | Revendication concernée | |
| A | US - A - 3 637 994 (ELLINGBOE)<br>* Figures 4 et 5; colonne 5, ligne 58 - colonne 6, ligne 9 *<br><br>-- | 1 | G 06 K 19/06 |
| A | US - A - 3 702 464 (CASTRUCCI)<br>* Figures 1-4, colonne 3, ligne 35 - colonne 4, ligne 60 *<br><br>-- | 1 | |
| A | FR - A - 2 337 381 (COMP. HONEY-WELL BULL)<br>* Figures 1-11 *<br><br>-- | 1 | **DOMAINES TECHNIQUES RECHERCHES (Int. Cl.³)**<br><br>G 06 K 19/06 |
| AD | EP - A - 0 029 785 (SOC. FLONIC)<br>& FR - A - 7 929 115<br><br>---- | 1 | |

**CATEGORIE DES DOCUMENTS CITES**

X: particulièrement pertinent
A: arrière-plan technologique
O: divulgation non-écrite
P: document intercalaire
T: théorie ou principe à la base
   de l'invention
E: demande faisant interférence
D: document cité dans
   la demande
L: document cité pour d'autres
   raisons
&: membre de la même famille,
   document correspondant

Le présent rapport de recherche a été établi pour toutes les revendications

| Lieu de la recherche | Date d'achèvement de la recherche | Examinateur |
|---|---|---|
| La Haye | 10-07-1981 | PESCHEL |

OEB Form 1503.1  06.78